# EUROPEAN PATENT APPLICATION

(11) **EP 2 397 745 A2**
(43) Date of publication of application: **21.12.2011**
(21) Application number: 11169813.0
(22) Date of filing: 14.06.2011
(51) Int. Cl.: F21K 99/00, F21Y 101/02

(54) **Light-emitting device and luminaire**

(30) Priority: 17.06.2010 JP 2010138767
(71) Applicant: Toshiba Lighting & Technology Corporation, Yokosuka-shi Kanagawa 237-8510 (JP)
(72) Inventor: Shibusawa, Soichi, Kanagawa, 237-8510 (JP); Betsuda, Nobuhiko, Kanagawa, 237-8510 (JP); Nishimura, Kiyoshi, Kanagawa, 237-8510 (JP); Matsuda, Shuhei, Kanagawa, 237-8510 (JP); Kumagai, Masatoshi, Kanagawa, 237-8510 (JP)
(74) Representative: Sander Jakobsson, Sofia Ellinor

(57) **Abstract**

According to one embodiment, a light-emitting device (1) includes a substrate (2), a plurality of light-emitting elements (3) and a sealing resin (4). The substrate (2) is formed in a substantially rectangular shape. The plurality of light-emitting elements (3) forms a plurality of rows (30) by being arranged in a direction perpendicular to a longer dimension of the substrate (2). The rows (30) are arranged in a longer direction of the substrate (2) with a gap provided therebetween. The gap is set between the rows (30) such that illumination intensity is evenly produced. The sealing resin (4) coves each of the rows (30) of the light-emitting elements (3).

## Description

### FIELD

Embodiments described herein relate generally to a light-emitting device and a luminaire which equips a light-emitting element such as a light emitting diode (LED).

### BACKGROUND

A luminaire in which a plurality of light-emitting elements such as LEDs are provided as a light source on a substrate to obtain a certain amount of light has been developed. Such a luminaire is a so-called "direct-mounting type" which is base light that can be directly fitted to a wall surface such as the ceiling. In this luminaire, the plurality of LEDs are mounted on a substrate in a matrix shape.

However, in such a luminaire, no consideration is given to the efficient dimensions of the substrate or a layout pattern of the light-emitting elements in terms of the efficiency in production or a work for mounting the light-emitting elements.

### BRIEF DESCRIPTION OF THE DRAWINGS

FIG. 1 is a partially cutaway plan view of a light-emitting device according to an embodiment;
FIG. 2 is a plan view of a wiring pattern and a mounting pad of a substrate illustrated in FIG. 1;
FIG. 3 is an enlarged plan view of an area A in FIG. 1;
FIG. 4 is a cross sectional view taken along a line F4 - F4 in FIG. 1;
FIG. 5 is a wiring diagram of light-emitting elements of the light-emitting device illustrated in FIG. 1; and
FIG. 6 is a perspective view of a luminaire of a ceiling direct-mounting type provided with the light-emitting device illustrated in FIG. 1.

### DETAILED DESCRIPTION

In general, according to one embodiment, a light-emitting device and a luminaire, which are advantageous in handling as compared with the conventional ones and emit uniform light as a whole, are provided.

According to one embodiment, a light-emitting device includes a substrate, a plurality of light-emitting elements and a sealing resin. The substrate is formed in a substantially rectangular shape. The plurality of light-emitting elements forms a plurality of rows by being arranged in a direction perpendicular to a longer dimension of the substrate. The rows are arranged in a longer direction of the substrate with a gap provided therebetween. The gap is set between the rows such that no unevenness in illumination intensity is produced. The sealing resin coves each of the rows of the light-emitting elements.

This light-emitting device is provided with a substrate, light-emitting elements, and a sealing resin. The substrate has a length of equal or more than 250 to equal or less than 300 mm and a rectangular shape. The light-emitting elements are mounted in such a way that a plurality of light-emitting elements are arranged in a row in a direction perpendicular to a longer direction of the substrate, and a plurality of such rows are arranged in the longer direction of the substrate. The distance between the adjacent rows is set at equal or more than 12 to equal or less than 18 mm. The sealing resin covers each of the rows formed by arranging the plurality of light-emitting elements in the direction perpendicular to the longer direction.

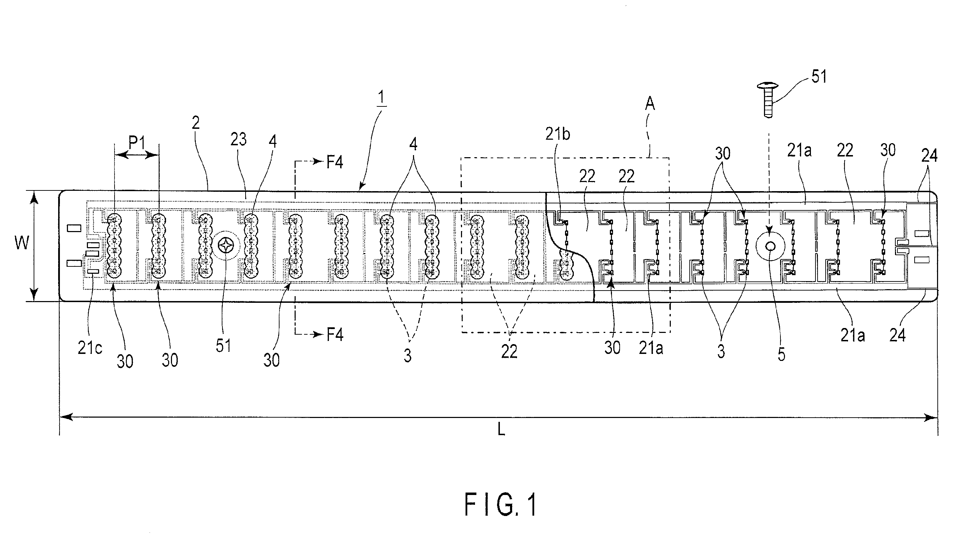

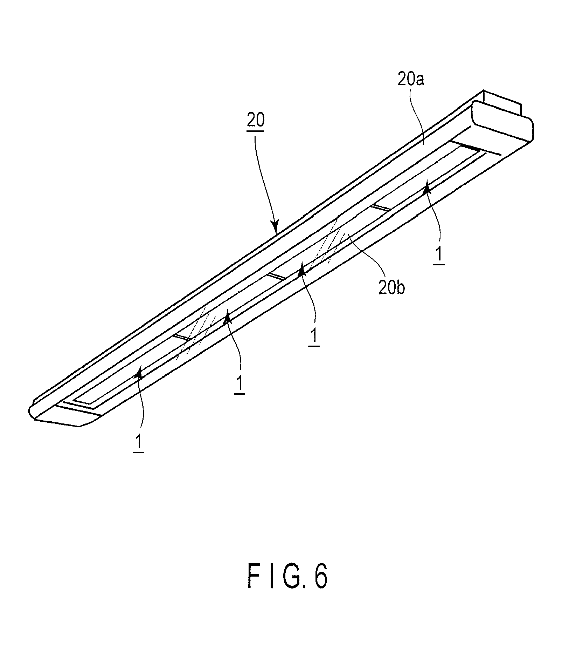

A first embodiment will be described with reference to FIGS. 1 to 6. FIGS. 1 to 5 illustrate a light-emitting device 1, and FIG. 6 illustrates a luminaire 20 provided with the light-emitting device 1.

As illustrated in FIG. 1, the light-emitting device 1 is provided with a substrate 2, a plurality of light-emitting elements 3, and a phosphor layer 4 covering each of the light-emitting elements 3 as a sealing resin. FIG. 1 illustrates the light-emitting device 1 from which a resist layer 23 and the phosphor layer 4 are partially removed.

The substrate 2 is made of a glass epoxy resin and formed in an elongated rectangular shape. A length L of the substrate 2 is equal or more than 250 mm to equal or less than 300 mm, and a width W is equal or more than 30 mm to equal or less than 40 mm. A thickness of the substrate 2 is 0.5 mm or larger but 1.8 mm or smaller. In this embodiment, the length L is 280 mm, the width W is 32 mm, and the thickness is 1 mm.

The shape of the substrate 2 may be an elongated oval shape having both ends thereof in the longer direction formed in a rounded shape. In addition, it is also possible to use a ceramics material or other synthetic resin materials as a material for the substrate 2. Further, as the substrate, this embodiment does not preclude using a substrate with a metallic base plate to increase heat radiation of each of the light-emitting elements 3. Such a substrate is formed by laminating an insulating layer on one surface of a base plate such as aluminum having high thermal conductivity and excellent heat radiation performance.

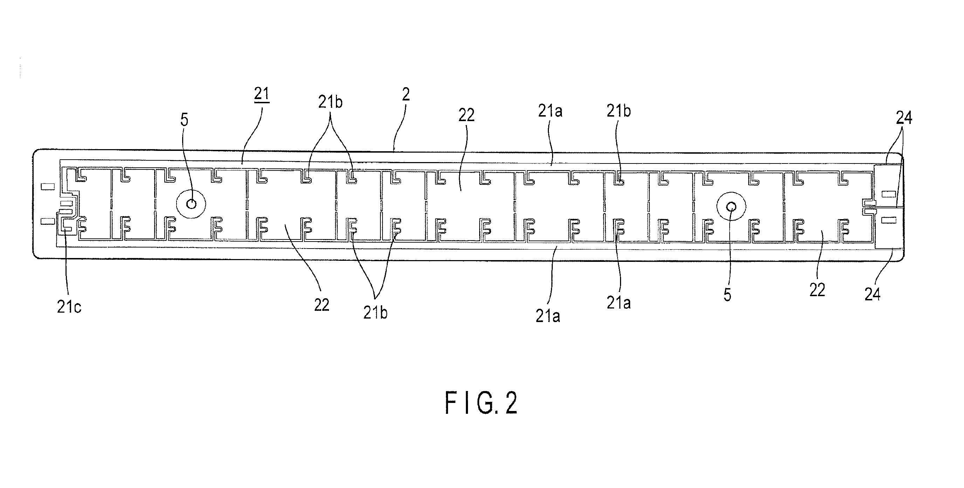

As illustrated in FIG. 2 as a representative drawing, the substrate 2 includes a wiring pattern 21 and mounting pads 22 on an obverse side thereof. The wiring pattern 21 includes power supply conductors 21a, power supplying posts 21b, and a power receiving terminal 21c. The power supply conductors 21a are arranged as a pair of positive and negative poles extending linearly in parallel to each other along the longer side of the substrate 2 with a distance provided from each other in a direction crossing the longer direction. Each of the power supply conductors 21a includes the plurality of power supplying posts 21b extending inwardly at predetermined intervals.

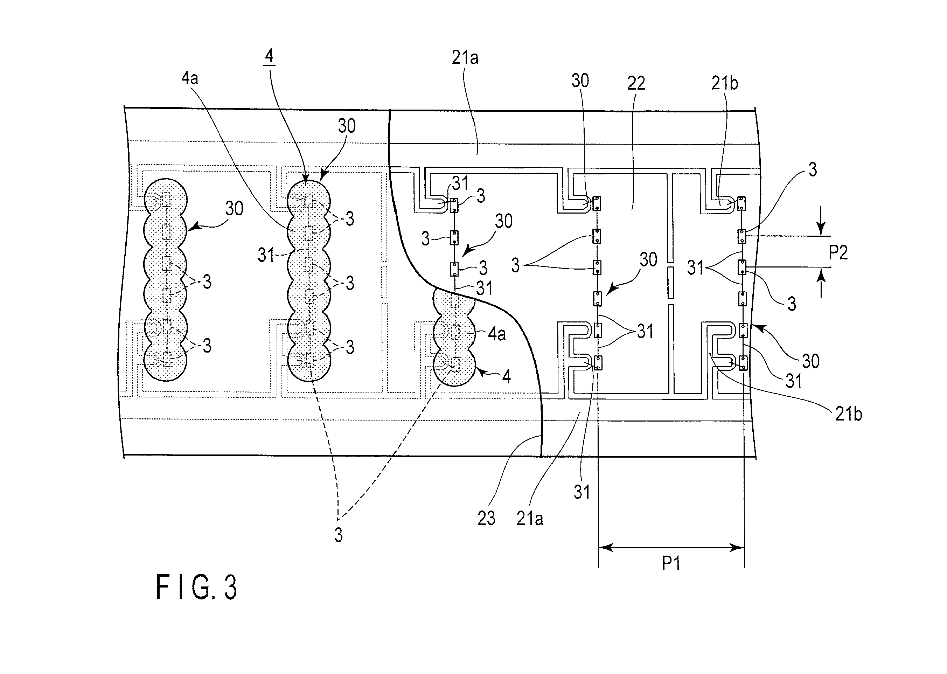

Referring to FIGS. 2 and 3, the power supplying posts 21b extending downward from the power supply conductor 21a illustrated in an upper part of the drawing are formed in an L-shape, and eighteen pieces thereof are arranged at regular intervals. Referring to FIGS. 2 and 3, the power supplying posts 21b extending upward from the power supply conductor 21a illustrated in a lower part of the drawing are formed in an F-shape, and eighteen pieces thereof are arranged at regular intervals in a manner to face the power supplying posts 21b having the L-shape. The power supplying post 21b having the L-shape has one terminal, and the power supplying post 21b having the F-shape has two terminals.

As illustrated in FIGS. 2 and 3, the mounting pads 22 are arranged between the two power supply conductors 21a and form a plurality of blocks thereof with insulation distances from the power supply conductors 21a and the power supplying posts 21b. Although the mounting pads 22 are not electrically connected to the light-emitting elements 3, they are connected in a manner to establish electric conductivity for performing electrolytic plating which will be described later.

As illustrated in FIG. 2, the power receiving terminal 21c is provided at an end portion of the substrate 2 and is connected to the power supply conductors 21a. A power connector is connected to this power receiving terminal 21c.

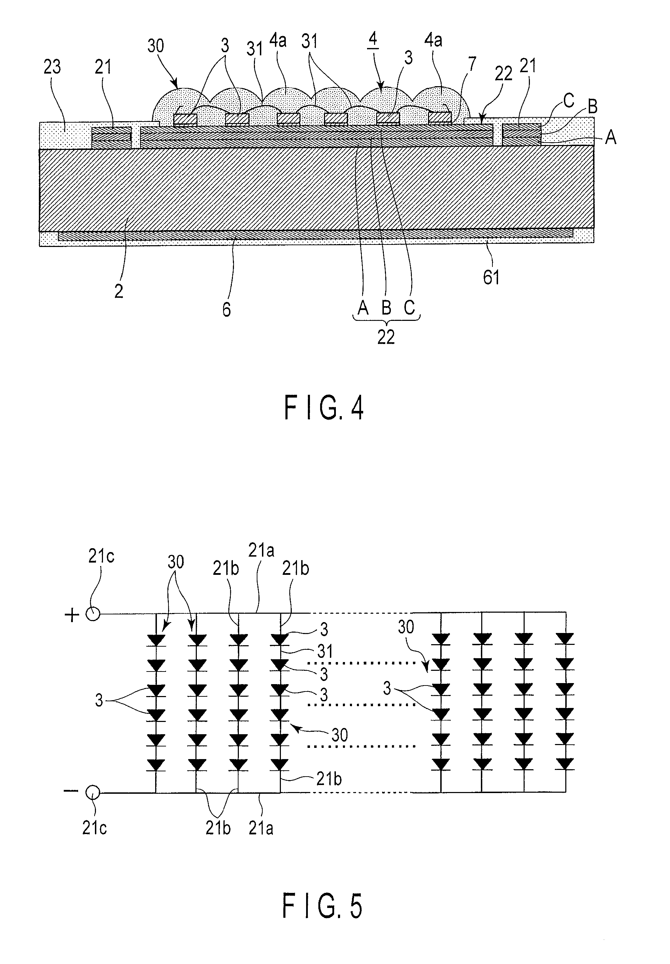

As illustrated in FIG. 4, the wiring pattern 21 and the mounting pads 22 have a three-layer structure comprising, from the lowermost layer to the obverse side of the substrate 2, a first layer A formed of copper (Cu), a second layer B formed of nickel (Ni), and a third layer C formed of silver (Ag) having a high reflectance, formed by electrolytic plating. Since the third layer C of the mounting pads 22, that is, silver (Ag) formed as a surface layer by electrolytic plating, has a high reflectance, it functions as a reflecting layer. According to this embodiment, a whole ray reflectance of the third layer C is 90%.

A thickness of nickel (Ni) of the second layer B formed by electrolytic plating is 5 µm and more, and a thickness of silver (Ag) of the third layer C is 1 µm and more. By arranging the thicknesses of the layers as described above, the layer thicknesses are formed uniformly, and thus a uniform reflectance can be obtained.

As illustrated in FIGS. 1 and 4, a white resist layer 23 having a high reflectance is laminated on almost the entire obverse side of the substrate 2 excluding mounting areas where the light-emitting elements 3 are mounted and mounting portions where components are mounted.

As illustrated in FIGS. 1, 3, and 4, each of the light-emitting elements 3 is a bare tip of an LED. The bare tip of an LED that emits blue light is used so that a light-emitting portion of the light-emitting device 1 is made to output light of white color. As illustrated in FIG. 4, the light-emitting elements 3 are bonded onto the mounting pad 22 with a silicone resin-based insulating adhesive 7.

In this embodiment, the light-emitting element 3 is a bare tip of Indium-Gallium-Nitride series (InGaN) and has a structure in which a light-emitting layer is laminated on a translucent sapphire substrate. The light-emitting layer is formed by laminating sequentially an n-type nitride semiconductor layer, an InGaN layer, and a p-type nitride semiconductor layer. Electrodes for supplying current to the light-emitting layer are formed of a positive electrode that is formed by a p-type electrode pad on the p-type nitride semiconductor layer and a negative electrode that is formed by an n-type electrode pad on the n-type nitride semiconductor layer. As illustrated in FIGS. 3 and 6, these electrodes are electrically connected by bonding wires 31. Each of the bonding wires 31 is a thin wire made of gold (Au) and is connected through a bump formed of gold (Au) as a principal component to enhance a packaging strength and reduce damage to the light-emitting elements 3.

The plurality of light-emitting elements 3 are arranged and mounted on the mounting pads 22 of the substrate 2 in a manner to form rows 30 in a direction perpendicular to the longer direction of the substrate 2. As illustrated in FIG. 1, the plurality of rows 30 of the light-emitting elements 3 are arranged at regular intervals along the longer direction of the substrate 2. Six pieces of the light-emitting elements 3 are arranged at regular intervals between each of the power supplying posts 21b of the power supply conductor 21a illustrated in the upper part of FIGS. 1 and 3 and each of the power supplying posts 21b of the power supply conductor 21a illustrated in the lower part of the drawings. As illustrated in FIG. 1, eighteen rows 30 of the light-emitting elements 3 are formed in the longer direction of the substrate 2. This means that the light-emitting elements 3 are arranged in eighteen rows, each including six pieces of the light-emitting elements 3.

In each of the rows 30, individual electrodes of the light-emitting elements 3 are connected, by bonding wires 31, to electrodes with opposite polarities of the individual light-emitting elements 3 arranged adjacent thereto in a direction in which the row 30 extends. To be specific, as illustrated in FIG. 3, a positive electrode of a light-emitting element 3 disposed midway in the row 30 is connected to a negative electrode of a light-emitting element 3 located on one side next thereto, and a negative electrode of the light-emitting element 3 is connected to a positive electrode of a light-emitting element 3 located next thereto on the other side. This means that the plurality of light-emitting elements 3 forming each of the rows 30 are electrically connected in series. Accordingly, the light-emitting elements 3 of the same row 30 emit light all together when the subject row 30 is energized.

In FIGS. 1 and 3, the electrode of the light-emitting element 3 arranged at the top end of each row 30 is connected, by the bonding wire 31, to an upper terminal of the power supplying post 21b having the L-shape. The electrode of the light-emitting element 3 arranged at the bottom end of each row 30 is connected, by the bonding wire 31, to a lower one of two terminals of the F-shaped power supplying post 21b located on the lower side. In this specification, in the row 30 of the light-emitting elements 3, the light-emitting elements 3 are connected to one another by the bonding wires 31 in series, and the light-emitting elements 3 are arranged linearly in structure.

In the light-emitting device 1 according to the first embodiment, each of the rows 30 is formed of six pieces of the light-emitting elements 3. When each of the rows 30 is formed of five pieces of the light-emitting elements 3, in FIG. 3, the electrode of the light-emitting element 3 at the bottom end is connected to an upper one of the two terminals of the F-shaped power supplying post 21b located on the lower side in the drawing. This means that the same substrate 2 can be used regardless of whether the number of the light-emitting elements 3 in each of the rows 30 is set at five or six. In this way, if a plurality of terminals are branched out from the power supplying post 21b, the number of the light-emitting elements 3 in a single row can be arbitrarily selected in accordance with the specifications by using the same substrate.

As illustrated in FIG. 3, a distance P1 between centers of the adjacent rows 30 among the plurality of rows 30 is set at equal or more than 12 mm to equal or less than 18 mm. In addition, a distance P2 between the adjacent light-emitting elements 3 in a direction in which each of the rows 30 extends is set at equal or more than 3 mm to equal or less than 3.5 mm.

If the distance P1 between the rows 30 is set at equal or more than 12 mm to equal or less than 18 mm, the illumination intensity of the light emitted from the entire light-emitting device 1 becomes substantially uniform at a position of a front cover 20b when this light-emitting device 1 is employed as a light source for the luminaire 20 illustrated in FIG. 6. For this reason, if the distance P1 is set larger than the foregoing figures, a darker area is caused between the adjacent rows 30 due to a difference in luminance, which becomes conspicuous. Also, if the distance P1 is set smaller than the foregoing figures, the light-emitting elements 3 are too densely arranged, which serves as a factor to lower the luminous efficiency due to an increase in temperature or the like.

The inventors of this light-emitting device 1 changed the distance P1 between the rows 30 of the light-emitting elements 3, and measured the illumination intensity and the luminance. As a result, they obtained a result to the effect that it is preferable that the distance P1 be set at equal or more than 12 mm to equal or less than 18 mm. It is also confirmed that, when the distance P2 between the light-emitting elements 3 arranged in a single row 30 is set at equal or more than 3 mm to equal or less than 3.5 mm, it is possible to suppress a phenomenon in which the independent glowing of each of the light-emitting elements 3 becomes visible, i.e., so-called spotted marks, and also suppress overheating of the light-emitting elements 3.

The individual light-emitting elements 3 of the light-emitting device 1 arranged as described above are connected as depicted by the wiring diagram illustrated in FIG. 5. According to this wiring diagram, the light-emitting device 1 is formed by connecting, in parallel, eighteen series circuits, each of which includes six light-emitting elements 3 connected in series. Individual rows 30 of the light-emitting elements 3 are arranged in parallel electrically to which power is supplied through the wiring pattern 21. With this arrangement, even if any one row 30 or any plurality of rows 30 of the eighteen rows cannot be energized due to false bonding or the like, the light-emitting device 1 keeps lighting by means of the light-emitting elements 3 of the other rows 30.

As illustrated in FIGS. 1 and 2, the substrate 2 includes, between adjacent rows 30 in areas toward the ends thereof, fitting holes 5 penetrating in a thickness direction of the substrate 2. These fitting holes 5 are used to fasten the light-emitting device 1 to the case 20a of the luminaire 20 illustrated in FIG. 6. When the light-emitting device 1 is incorporated into the luminaire 20, fitting screws 51 serving as fastening means are inserted through the fitting holes 5 and screwed into the case 20a of the luminaire 20.

In the case of the conventional light-emitting device 1, since the light-emitting elements 3 are densely arranged, the fitting holes 5 for fastening the light-emitting device 1 are provided toward both ends of the substrate 2. Accordingly, it is necessary to provide an additional surplus length, which makes the substrate 2 bulky by the amount of the surplus length.

However, according to the light-emitting device 1 of the first embodiment, since the distance P1 between the rows 30 of the light-emitting elements 3 is set at equal or more than 12 mm to equal or less than 18 mm, it is possible to open the fitting hole 5 between the rows 30 and fasten the light-emitting device 1 by the fastening means such as the fitting screw 51 without enlarging the substrate 2. If the fastening means is metallic, an insulation distance is secured between the wiring pattern 21 and the fastening means. The fastening means does not fasten the both ends of the substrate 2 but fastens the middle portion of the substrate 2. Accordingly, the light-emitting device 1 can effectively prevent, by the fastening means, the substrate 2 from being deformed such as warpage. Here, it is also possible to use an insulating material such as a synthetic resin as the fastening means.

As illustrated in FIGS. 1 and 2, the substrate 2 includes three connection patterns 24 at an end opposite to a side on which the power receiving terminal 21c is arranged. The connection patterns 24 are connected to each of the power supply conductors 21a and the mounting pads 22 and used when the wiring pattern 21 and the mounting pads 22 are formed by electrolytic plating. To be more specific, the connection patterns 24 function as a connection path to make each of the wiring pattern 21 and the mounting pads 22 equipotential when nickel (Ni) of the second layer B and silver (Ag) of the third layer C are plated on the pattern of copper (Cu) of the first layer A by electrolytic plating.

As illustrated in FIGS. 1, 3, and 4, the phosphor layer 4 is made of a translucent synthetic resin, e.g., a translucent silicone resin in the first embodiment, and contains an appropriate amount of a phosphor including cerium doped Yttrium-Aluminum-Garnet (YAG:Ce)" as a main component. The phosphor layer 4 is formed of a plurality of cells 4a that respectively cover the individual light-emitting elements 3. Each of the cells 4a forms a rounded projection in a dome-like shape. The cells 4a covering the light-emitting elements 3 arranged in the same row 30 are linked, through bases thereof, with the cells 4a covering the adjacent light-emitting elements 3. Therefore, the phosphor layer 4 is formed along the row 30 of the light-emitting elements 3. To be specific, in the first embodiment, the phosphor layer 4 is formed for each of eighteen rows 30 arranged in the longer direction of the substrate 2, and covers and seals the light-emitting elements 3 and the bonding wires 31 in each of the rows 30.

The phosphor is excited by light emitted by the light-emitting element 3 and emits light of a specific color different from that of the light emitted by the light-emitting element 3. In the first embodiment, since the light-emitting element 3 emits blue light, a yellow phosphor that emits yellow light which is a complementary color to the blue light is used as a phosphor to be contained in the phosphor layer 4 so that white light is emitted as output light of the light-emitting device 1.

The phosphor layer 4 is applied, while it is not hardened, in a manner to correspond to each of the light-emitting elements 3 and each of the bonding wires 31 and is hardened thereafter through a heating process or leaving it intact for a predetermined period. In the first embodiment, a regulated amount of a translucent silicone resin material having regulated viscosity and containing a phosphor, while it is not hardened, is supplied from a dispenser so that it drips in a manner corresponding to each of the light-emitting elements 3 and each of the bonding wires 31 to thereby form the cell 4a.

Instead of covering the light-emitting elements 3 respectively by the individual cells 4a each of which is formed in a circular dome-like shape, the cell 4a may be formed by collectively covering two or more of the light-emitting elements 3 together.

As illustrated in FIG. 4, the substrate 2 is provided with a pattern of copper foil 6 for heat radiation which is formed on an entire surface of a reverse side thereof. Since the substrate 2 is provided with the copper foil 6, the heat of the entire substrate 2 is averaged out, which improves the heat radiation performance. The substrate 2 includes a resist layer 61 that covers the copper foil 6.

Next, referring to FIG. 6, a description will be given of the luminaire 20 equipping with the above-mentioned light-emitting device 1. The luminaire 20 illustrated in FIG. 6 is a ceiling direct-mounting type luminaire having a size similar to an ordinary luminaire of a 40 Watt [W] fluorescent type attached to the ceiling and used. The luminaire 20 is provided with a case 20a having an elongated and substantially rectangular parallelepiped shape. The case 20a includes a plurality of the light-emitting devices 1 illustrated in FIGS. 1 to 5, e.g., four light-emitting devices 1 that are connected linearly in this embodiment. A power supply unit provided with a power circuit is assembled in the case 20a. A front cover 20b having diffuseness is attached to an opening portion opened downwardly of the case 20a.

When power is supplied from the power circuit to the light-emitting device 1 arranged as described above, the light-emitting elements 3 are lit all together. When light output from the light-emitting element 3 passes through the phosphor layer 4 and is emitted, the light excites the phosphor in the phosphor layer 4 and causes the phosphor to be excited to emit light. When the output light from the light-emitting element 3 and the excited light from the phosphor layer 4 are combined together, it results in white light. Therefore, the light-emitting device 1 is used as a surface light source emitting white light.

In the first embodiment, the mounting pad 22 functions as a heat spreader that diffuses heat generated by each of the light-emitting elements 3 while the light-emitting elements 3 emit light. When the light-emitting device 1 emits light, light traveling to the substrate 2 among the light emitted from the light-emitting element 3 is almost entirely reflected by the reflecting layer formed in the surface layer of the mounting pad 22 to a direction in which the light is utilized. The light traveling in a direction along the substrate 2 among the light emitted from the light-emitting elements 3 is reflected by a surface of the white resist layer 23 having a high reflectance and emitted toward a front side, i.e., a direction in which the light is utilized. This means that the light-extraction efficiency of this light-emitting device 1 is excellent.

The length L of the substrate 2 of this light-emitting device 1 is set at equal or more than 250 mm to equal or less than 300 mm. The length of an ordinary luminaire, i.e., 40 Watt [W] fluorescent type light used as base light that is of a ceiling direct-mounting type, is equal or more than 1200 mm to equal or less than 1300 mm. Accordingly, if a part or whole of the ordinary luminaire is replaced with the light-emitting device 1 according to the first embodiment, four of the substrates 2 are arranged and used so that the length thereof fits in terms of the length. Then, it harmonizes with the surrounding luminaires and is easy to install. In addition, the length of the light-emitting device 1 according to this embodiment is not excessively long and advantageous in manufacturing and handling.

Further, in this light-emitting device 1, the plurality of light-emitting elements 3 form the rows 30 in each of which the plurality of light-emitting elements 3 are arranged on the mounting pads 22 in a direction perpendicular to the longer direction of the substrate 2. Accordingly, a desired output of the light-emitting device 1 can be set by appropriately selecting the number of rows 30 of the light-emitting elements 3.

As described above, according to the light-emitting device 1 of this embodiment, since the row 30 formed of the light-emitting elements 3 is appropriately distanced from the adjacent row 30, the heat generated by the light-emitting elements 3 can be efficiently radiated while the illumination intensity and luminance of the light emitted from the light-emitting device 1 is maintained uniformly. At the same time, since the length L of the substrate 2 is set at equal or more than 250 mm to equal or less than 300 mm, and the distance P1 between the rows 30 of the light-emitting elements 3 is set at equal or more than 12 mm to equal or less than 18 mm, the light-emitting device 1 has excellent versatility, and the illumination intensity and luminance of the light output from the light-emitting device 1 become uniform. Further, the luminaire 20 equipped with the light-emitting device 1 also has excellent versatility and outputs light of uniform illumination intensity and luminance.

A fitting hole 5 is formed between the rows 30 of the light-emitting elements 3 for fastening the substrate 2 of the light-emitting device 1, and the substrate 2 is fastened by a fitting screw 51 that is screwed in through the fitting hole 5. This prevents the substrate 2 from becoming bulky.

The present invention is not limited to the specific details of the embodiment described above. Accordingly, various modifications may be made without departing from the spirit or scope of the invention. For example, elements of point-source light other than the solid-state semiconductor elements such as LEDs may be used as the light-emitting element 3. Instead of the light-emitting elements 3, the row 30 of the light-emitting elements 3 may be formed of a single light-emitting unit. The number of light-emitting elements 3 that constitute the row 30 or the number of rows 30 are not specifically restricted. Further, the luminaire 20 provided with a plurality of the light-emitting devices 1 may be used as a luminaire for indoor or outdoor use, or as a light source to be installed in a display apparatus or the like.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting device (1) **characterized by** comprising:
a substrate (2) formed in a substantially rectangular shape;
a plurality of light-emitting elements (3) forming a plurality of rows (30) by being arranged in a direction perpendicular to a longer dimension of the substrate (2), said rows (30) being arranged in a longer direction of the substrate with a gap provided therebetween, said gap being set between the rows (30) such that illumination intensity is evenly produced; and
a sealing resin (4) covering each of the rows (30) of the light-emitting elements (3).

2. The light-emitting device (1) of Claim 1, **characterized in that** a length of the substrate (2) is equal or more than 250 mm to equal or less than 300 mm, and
the gap between the rows (30) of the light-emitting elements (3) is equal or more than 12 mm to equal or less than 18 mm.

3. The light-emitting device (1) of Claim 1, **characterized in that** the substrate (2) includes at least one fitting hole (5), between the rows (30) that are adjacent to each other, for fastening the substrate (2).

4. An luminaire (20) **characterized by** comprising:
a main body; and
a light-emitting device (1) comprising:
a substrate (2) formed in a substantially rectangular shape;
a plurality of light-emitting elements (3) forming a plurality of rows (30) by being arranged in a direction perpendicular to a longer dimension of the substrate (2), said rows (30) being arranged in a longer direction of the substrate with a gap provided therebetween, said gap being set between the rows (30) such that illumination intensity is evenly produced; and
a sealing resin (4) covering each of the rows (30) of the light-emitting elements (3).

5. The luminaire (20) of Claim 4, **characterized in that** a length of the substrate (2) is equal or more than 250 mm to equal or less than 300 mm, and
the gap between the rows (30) of the light-emitting elements (3) is equal or more than 12 mm to equal or less than 18 mm.

6. The luminaire (20) of Claim 4, **characterized in that** the substrate (2) includes at least one fitting hole (5), between the rows (30) that are adjacent to each other, for fastening the substrate (2).
